(19) Europäisches Patentamt
European Patent Office
Office européen des brevets

(11) Publication number: 0 012 583
B1

(12) EUROPEAN PATENT SPECIFICATION

(45) Date of publication of patent specification: 15.02.84

(51) Int. Cl.³: C 04 B 35/49, H 01 L 41/18

(21) Application number: 79302828.3

(22) Date of filing: 07.12.79

# (54) Piezoelectric ceramic production.

(30) Priority: 08.12.78 JP 152400/78
06.03.79 JP 26394/79
20.07.79 JP 93021/79

(43) Date of publication of application:
25.06.80 Bulletin 80/13

(45) Publication of the grant of the patent:
15.02.84 Bulletin 84/7

(84) Designated Contracting States:
DE FR GB IT

(56) References cited:
DE - A - 1 646 775
US - A - 3 890 241
US - A - 3 956 150
US - A - 3 963 631
US - A - 4 059 537
US - A - 4 062 790
US - A - 4 124 671

(73) Proprietor: Matsushita Electric Industrial Co., Ltd.
1006, Oaza Kadoma
Kadoma-shi Osaka-fu, 571 (JP)

(72) Inventor: Nishida, Masamitsu
2, Komatsu Nakadoori 3 chome
Higashiyodogawa-ku
Osaka-shi Osaka-fu (JP)
Inventor: Kawashima, Syunichiro
1-2-1005, Izumi-cho
Nishinomiya-shi Hyougo-ken (JP)
Inventor: Ueda, Ichiro
1-5-218, Morinomiya Joulou-ku
Osaka-shi Osaka-fu (JP)
Inventor: Ouchi, Hiromu
18-2, Shinsenrinishimachi 2 chome
Toyonaka-shi Osaka-fu (JP)

(74) Representative: Spencer, Graham Easdale et al,
A.A. Thornton & CO Northumberland House 303-306, High Holborn
London WC1V 7LE (GB)

EP 0 012 583 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Piezoelectric ceramic production

This invention is concerned with a method of preparing piezoelectric ceramics, particularly such ceramics having high piezoelectric response for use in, for example, ultrasonic transducers and ceramic filters.

Lead titanate-lead zirconate ceramics, ternary system

$Pb(Mg_{1/3}Nb_{2/3})O_3$—$PbTiO_3$—$PbTiO_3$—$PbZrO_3$ ceramics and quaternary system

$$Pb(Zn_{1/3}Nb_{2/3})O_3 — Pb(Sn_{1/3}Nb_{2/3})O_3 — PbTiO_3 — PbZrO_3$$

ceramics have been used as piezoelectric ceramics.

These piezoelectric ceramics are commonly made by sintering of the appropriate ceramic composition and then polarizing the material by applying a D.C. voltage so as to impart electromechanical transducing properties thereto.

It would be desirable to provide piezoelectric ceramics of improved electromechanical coupling factor to obtain higher piezoelectric response, but it is difficult to make much improvement by refining the composition.

U.S. Patent 3956150 discloses a method of preparing various lead titanate-lead zirconate piezoelectric ceramics by sintering at 1200 to 1300°C followed by heat treatment for 1 to 60 hours at a temperature 100 to 400°C lower than the sintering temperature (that is, at 800 to 1200°C), followed by cooling at a defined rate. The purpose of the heat treatment in the method disclosed in the above-mentioned U.S. patent is to improve the tensile strength of the resulting ceramic material; in addition, the patent discloses that there is some decrease of the resonant impedance.

We have now discovered that an effect not disclosed in the above-mentioned U.S. patent, that is, an increase in the electromechanical coupling factor, can be obtained by heat treatment at a lower temperature than the heat treatment temperature specified in the U.S. patent.

According to the invention, therefore, there is provided a method of increasing the electromechanical coupling factor of a piezoelectric ceramic material prepared by heat treating, for 0.5 to 60 hours, a sintered ceramic material of the composition:

I. $(1-w)(PbTi_{1-z}Zr_zO_3) + wMnO_2$, wherein $0.004 \leqslant w \leqslant 0.06$, $0.48 \leqslant z \leqslant 0.64$, and up to 10 atomic % of Pb may be replaced by one or more of Sr, Ca and Ba, or

II.

$$Pb([B_1]_ANb_{1-A})O_3—PbTiO_3—PbZrO_3 \text{ with } MnO_2,$$
$$Pb([B_2]_BNb_{1-B})O_3—Pb([B_3]_CNb_{1-C})O_3—PbTiO_3—PbZrO_3 \text{ with } MnO_2,$$
$$Pb(Mn_{1/3}Nb_{2/3})O_3—PbTiO_3—PbZrO_3, \text{ or}$$
$$Pb([B_4]_DNb_{1-D})O_3—Pb(Mn_{1/3}Nb_{2/3})O_3—PbTiO_3—PbZrO_3,$$

wherein $B_2 \neq B_3$, each of $B_1$, $B_2$, $B_3$ and $B_4$ is one or more of Mg, Zn, Cd, Sn, Fe, Co and Ni when

$$A, B, C \text{ and } D = \frac{1}{3},$$

and Li and/or Cu when

$$A, B, C \text{ and } D = \frac{1}{4},$$

and up to 20 atomic % of Pb may be replaced by one or more of Sr, Ca and Ba, characterized in that the heat treatment is at a temperature of 500 to 700°C.

The resulting piezoelectric ceramics have much higher electromechanical coupling factors than ones which have not been heat treated.

The sintered ceramic material used in the method according to the invention is preferably made by mixing the ingredients in appropriate (weighed) proportions, calcining the mixture, pulverizing the calcined material, shaping the powder thus obtained, and then sintering the shaped body.

Before calcining, the ingredients may be mixed in the wet in a ball mill and then filtered and dried. The calcined material may be pulverized by wet-grinding, followed by filtering and drying.

The sintering may be effected without pressing or with hot-pressing, for example, at a temperature of 1050 to 1300°C and a pressure of 100 to 500 kg/cm² for 0.5 to 24 hours. Such hot-press sintering conditions are suitable for obtaining ceramic of high mechanical strength.

In order that the present invention may be more fully understood, the following Examples are given by way of illustration only.

Example 1

Ceramics of the formula $[(1-w)(PbTi_{1-z}Zr_zO_3) + wMnO_2]$, wherein $0.48 \leqslant z \leqslant 0.64$ and $0.004 \leqslant w \leqslant 0.06$ and one or more of Sr, Ca and Ba may be replaced by up to 10% of Pb, were produced as follows.

PbO, $TiO_2$, $ZrO_2$, $MnO_2$ and $SrCO_3$ were weighed in the proportions of

$$[0.992(Pb_{0.95}Sr_{0.05}Ti_{0.44}Zr_{0.56}O_3) + 0.008\ MnO_2]$$
and
$$[0.984\ (PbTi_{0.44}Zr_{0.56}O_3) + 0.016\ MnO_2]$$

(these being specific examples of the above formula). The mixtures were wet-mixed for 17 hours in a ball-mill and the slurries obtained were filtered, dried and then calcined at about 850°C for 2 hours. The resulting materials were wet ground, filtered, dried and then shaped into discs having a diameter of 13 mm and a thickness of 1 mm by compressing at a pressure of 500 kg/cm². The discs were sintered for 1 hour at 1280°C for the former composition and 1260°C for the latter composition.

The sintered discs were then heat treated at 500 to 700°C for 0.5 to 60 hours in air atmosphere and the resulting ceramic discs were polished into discs having a thickness of 0.3 mm as one kind of specimen. As another kind of specimen, the obtained ceramic discs were cut off into rods of dimensions 5 × 1 × 1 mm³. After having gold electrodes attached thereto, the specimens were subjected to a DC field of 3 to 5 kV/mm for 30 minutes in a silicone oil at a temperature of 160°C. The resulting specimens had electromechanical coupling factors $k_t$ and $k_{33}$ (measured at room temperature) as shown in Tables 1 and 2. The corresponding properties of not heat-treated specimens are also given in Tables 1 and 2 for comparison.

When Sr, Ba or Ca replaced more than 10 atomic % of the Pb, the $k_t$ value decreased remarkably.

Example 2

Ceramics having the same formulae as in Example 1 i.e.,

$$[0.992(Pb_{0.95}Sr_{0.05}Ti_{0.44}Zr_{0.56}O_3) + 0.008\ MnO_2]$$
and
$$[0.984\ (PbTi_{0.44}Zr_{0.56}O_3) + 0.016\ MnO_2]$$

were produced. The raw materials were wet-mixed for 17 hours in a ball mill and the slurries obtained were filtered, dried and then calcined at about 850°C for 2 hours. The resulting materials were wet-ground, filtered and dried and then shaped into discs having a diameter of 30 mm and a thickness of 17 mm under a pressure of 500 kg/cm². The discs were hot-press sintered at a temperature of 1250°C and a pressure of 200 kg/cm² for 4 hours.

The sintered discs were cut into discs of diameter 8 mm and thickness 0.3 mm and rods having the dimensions of 5 × 1 × 1 mm³. These discs and rods were heat treated at 500 to 700°C for 0.5 to 60 hours. Gold electrodes were attached thereto and the samples were subjected to a DC field of 3 to 5 kV/mm for 30 minutes in a silicon oil at a temperature of 160°C. The resulting specimens had electromechanical coupling factors $k_t$ and $k_{33}$ (measured at room temperature) as shown in Tables 3 and 4. The corresponding properties of not heat-treated specimens were also given in Tables 3 and 4 for comparison.

When Sr, Ca or Ba replaced more than 10 atomic% of the Pb, the $k_t$ value decreased remarkably.

Example 3

As raw materials, PbO, $TiO_2$, $ZrO_2$, $MnO_2$, $SrCO_3$, ZnO, $SnO_2$ and $Nb_2O_5$ were weighed respectively according to the compositions as indicated in Table 5. Each mixture was wet-mixed, filtered, dried and then calcined at about 850°C for 2 hours. The calcined materials were pulverized and shaped into discs of diameter 13 mm and thickness of 1 mm and also into discs of diameter 30 mm and thickness 17 mm. Then the former discs were sintered at 1250 to 1280°C for 60 minutes without pressure, and the latter discs were hot-press sintered at 1250°C and a pressure of 200 kg/cm² for 4 hours.

All the ceramic discs were then heat treated at 500 to 700°C for 0.5 to 60 hours. After the heat treatment, the former discs (which were not press-sintered) were polished to a thickness of 0.3 mm and the latter discs (which were hot-press sintered) were cut into discs of diameter 8 mm and thickness 0.3 mm. Gold electrodes were attached thereto and a DC field of 3 to 5 kV/mm was applied for 30 minutes in a silicone oil at a temperature of 100°C. The resulting specimens had electromechanical coupling factors $K_p$ and $k_t$ (measured at room temperature) as shown in Table 5. The corresponding properties of not heat-treated specimens are also given in Table 5 for comparison.

As apparent from Examples 1 to 3, the coupling factors $k_t$ and $k_{33}$ of piezoelectric ceramics are remarkably increased by heat treatment at 500 to 700°C for 0.5 to 60 hours after sintering. Such

effects of increasing coupling factor are especially remarkable in the case of lead titanate-lead zirconate ceramics modified with $MnO_2$. Heat treatment at a temperature of less than 500°C, or for less than 0.5 hours does not improve the piezoelectric properties, while heat treatment for more than 60 hours produces not so much increase of effect and results in a low productivity.

TABLE 1

| Heat treatment | | Coupling factor | |
|---|---|---|---|
| Temp. (°C) | Time (hr) | $k_t$ | $k_{33}$ |
| no heat treatment | | 0.50 | 0.61 |
| 500 | 60 | 0.52 | 0.62 |
| 600 | 24 | 0.53 | 0.64 |
| 700 | 4 | 0.54 | 0.68 |
| 700 | 60 | 0.56 | 0.71 |

Composition: 0.992 $(Pb_{0.95}Sr_{0.05}Ti_{0.44}Zr_{0.56}O_3)$ + 0.008 $MnO_2$

TABLE 2

| Heat treatment | | Coupling factor | |
|---|---|---|---|
| Temp. (°C) | Time (hr) | $k_t$ | $k_{33}$ |
| no heat treatment | | 0.48 | 0.58 |
| 500 | 60 | 0.49 | 0.60 |
| 700 | 24 | 0.52 | 0.63 |

Composition: 0.984 $(PbTi_{0.44}Zr_{0.56}O_3)$ + 0.016 $MnO_2$

TABLE 3

| Heat Treatment | | | |
|---|---|---|---|
| Temp. (°C) | Time (hr) | $k_t$ | $k_{33}$ |
| 500 | 60 | 0.53 | 0.63 |
| 600 | 24 | 0.54 | 0.65 |
| 700 | 4 | 0.54 | 0.64 |
| 700 | 60 | 0.56 | 0.68 |
| no heat treatment | | 0.51 | 0.62 |

Composition: 0.992 $(Pb_{0.95}Sr_{0.05}Ti_{0.44}Zr_{0.56}O_3)$ + 0.008 $MnO_2$

TABLE 4

| Heat Treatment | | $k_t$ | $k_{33}$ |
|---|---|---|---|
| Temp. (°C) | Time (hr) | | |
| 500 | 60 | 0.49 | 0.57 |
| 700 | 24 | 0.51 | 0.59 |
| no heat treatment | | 0.48 | 0.56 |

Composition: 0.984 ($PbTi_{0.44}Zr_{0.56}O_3$) + 0.016 $MnO_2$

TABLE 5

| Compositions | Sintering Conditions | | | Heat Treatment | | $k_p$ | $k_t$ |
|---|---|---|---|---|---|---|---|
| | Temp. (°C) | Pressure (Kg/cm²) | Time (hr) | Temp. (°C) | Time (hr) | | |
| $Pb_{0.95}Sr_{0.05}(Zn_{1/3}Nb_{2/3})_{0.09}(Sn_{1/3}Nb_{2/3})_{0.09}-Ti_{0.42}Zr_{0.40}O_3$ + 0.25 wt. % $MnO_2$ | 1280 | – | 1 | no treatment | | 0.55 | 0.48 |
| | | | | 500 | 60 | 0.56 | 0.49 |
| | | | | 700 | 24 | 0.57 | 0.51 |
| $Pb(Zn_{1/3}Nb_{2/3})$ $0.125Ti_{0.435}Zr_{0.440}O_3$ + 1 wt. % $MnO_2$ | 1250 | 200 | 4 | no treatment | | 0.48 | 0.44 |
| | | | | 700 | 60 | 0.50 | 0.47 |

## Claim

1. A method of increasing the electromechanical coupling factor of a piezoelectric ceramic material prepared by heat treating, for 0.5 to 60 hours, a sintered ceramic material of the composition:

I. $(1-w)(PbTi_{1-z}Zr_zO_3) + wMnO_2$, wherein $0.004 \leqslant w \leqslant 0.06$, $0.48 \leqslant z \leqslant 0.64$, and up to 10 atomic % of Pb may be replaced by one or more of Sr, Ca and Ba, or

II.

$$Pb([B_1]_A Nb_{1-A})O_3—PbTiO_3—PbZrO_3 \text{ with } MnO_2,$$
$$Pb([B_2]_B Nb_{1-B})O_3—Pb([B_3]_C Nb_{1-C})O_3—PbTiO_3—PbZrO_3 \text{ with } MnO_2,$$
$$Pb(Mn_{1/3}Nb_{2/3})O_3—PbTiO_3—PbZrO_3, \text{ or}$$
$$Pb([B_4]_D Nb_{1-D})O_3—Pb(Mn_{1/3}Nb_{2/3})O_3—PbTiO_3—PbZrO_3,$$

wherein $B_2 \neq B_3$, each of $B_1$, $B_2$, $B_3$ and $B_4$ is one or more of Mg, Zn, Cd, Sn, Fe, Co and Ni when

$$A, B, C \text{ and } D = \frac{1}{3},$$

and Li and/or Cu when

$$A, B, C \text{ and } D = \frac{1}{4},$$

and up to 20 atomic % of Pb may be replaced by one or more of Sr, Ca and Ba, characterized in that said heat treatment is at a temperature of 500 to 700°C.

## Revendication

1. Procédé d'augmentation du facteur de couplage électromécanique d'un matériau céramique piézoélectrique préparé par traitement thermique, pendant 0,5 à 60 heures, d'un matériau céramique fritté de composition:

I. $(1-w)(PbTi_{1-z}Zr_zO_3) + wMnO_2$, avec $0.004 \leqslant w \leqslant 0.06$, $0.48 \leqslant z \leqslant 0.64$, 10 atomes% au maximum de Pb pouvant être remplacés par un ou plusieurs éléments parmi Sr, Ca et Ba, ou

II.

$$Pb([B_1]_A Nb_{1-A})O_3—PbTiO_3—PbZrO_3 \text{ avec } MnO_2,$$
$$Pb([B_2]_B Nb_{1-B})O_3—Pb([B_3]_C Nb_{1-C})O_3—PbTiO_3—PbZrO_3 \text{ avec } MnO_2,$$
$$Pb(Mn_{1/3}Nb_{2/3})O_3—PbTiO_3—PbZrO_3, \text{ ou}$$
$$Pb([B_4]_D Nb_{1-D})O_3—Pb(Mn_{1/3}Nb_{2/3})O_3—PbTiO_3—PbZrO_3,$$

avec $B_2 \neq B_3$, chacun des $B_1$, $B_2$, $B_3$ et $B_4$ représentant un ou plusieurs éléments parmi Mg, Zn, Cd, Sn, Fe, Co et Ni lorsque

$$A, B, C \text{ et } D = \frac{1}{3},$$

et Li et/ou Cu lorsque

$$A, B, C \text{ et } D = \frac{1}{4},$$

20 atomes % au maximum de Pb pouvant être remplacés par un ou plusieurs éléments parmi Sr, Ca et Ba, caractérisé en ce que le traitement thermique est effectué à une température de 500 à 700°C.

**Patentanspruch**

Verfahren zur Vergrößerung des elektromechanischen Kopplungsfaktors eines piezoelektrischen Keramikmaterials, hergestellt durch Wärmebehandlung während 0,5 bis 60 Stunden eines gesinterten Keramikmaterials mit der Zusammensetzung:

I. $(1\text{-}w)\ (PbTi_{1-z}Zr_zO_3) + wMnO_2$, worin $0{,}004 \leq w \leq 0{,}06$, $0{,}48 \leq z \leq 0{,}64$, und bis zu 10 Atom-% des Pb ersetzt sein können durch eines oder mehrere von Sr, Ca und Ba, oder

II.

$$Pb([B_1]_A Nb_{1-A})O_3—PbTiO_3—PbZrO_2 \text{ mit } MnO_2,$$
$$Pb([B_2]_B Nb_{1-B})O_3—Pb([B_3]_C Nb_{1-C})O_3—PbTiO_3—PbZrO_3 \text{ mit } MnO_2,$$
$$Pb(Mn_{1/3}Nb_{2/3})O_3—PbTiO_3—PbZrO_3, \text{ oder}$$
$$Pb([B_4])_{D'} Nb_{1-D})O_3—Pb(Mn_{1/3}Nb_{2/3})O_3—PbTiO_3—PbZrO_3,$$

worin $B_2 \neq B_3$, jedes von $B_1$, $B_2$, $B_3$ und $B_4$ eines oder mehrere von Mg, Zn, Cd, Sn, Fe, Co und Ni ist, wenn A, B, C und D = 1/3, und Li und/oder Cu, wenn A, B, C und D = 1/4, und bis zu 20 Atom-% des Pb ersetzt sein können durch eines oder mehrere von Sr, Ca und Ba,
dadurch gekennzeichnet, daß die Wärmebehandlung bei einer Temperatur von 500 bis 700°C durchgeführt wird.